# EUROPEAN PATENT APPLICATION

(11) **EP 1 555 686 A2**
(43) Date of publication of application: **20.07.2005**
(21) Application number: 05290069.3
(22) Date of filing: 11.01.2005
(51) Int. Cl.: H01L 21/20, C30B 29/38, C30B 25/18

(54) **High quality nitride semiconductor thin film and method for growing the same**

(30) Priority: 15.01.2004 KR 2004002822
(71) Applicant: LG Electronics Inc., Seoul 150-875 (KR)
(72) Inventor: Kim, Min Hong, Goyang-si Gyeonggi-do 412-745 Seoul (KR)
(74) Representative: Loisel, Bertrand

(57) **Abstract**

The present invention relates to a high quality nitride semiconductor thin film and a method for growing the same. According to the present invention, mask material film patterns made of a dielectric or metallic material are formed on a substrate, the mask material film patterns are removed before coalescence is made while growing a nitride semiconductor thin film, and the nitride semiconductor thin film is laterally grown again. Thus, there is an advantage in that it is possible to grow a flat nitride semiconductor thin film with voids and fewer defects.

## Description

### BACKGROUND OF THE INVENTION

### 1. Field of the Invention

The present invention relates to a high quality nitride semiconductor thin film and a method for growing the same. More particularly, the present invention relates to a high quality nitride semiconductor thin film and a method for growing the same, wherein mask material film patterns made of a dielectric or metallic material are formed on a substrate, the mask material film patterns are removed before coalescence is made while growing a nitride semiconductor thin film, and the nitride semiconductor thin film is laterally grown again, thereby growing a flat nitride semiconductor thin film with voids and fewer defects.

### 2. Description of the Related Art

Generally, AlGaInN-based nitride semiconductor materials including GaN are materials, which have a light-emitting wavelength from ultraviolet to visible ranges and superior chemical and thermal stability. As such, applications of such materials to high temperature and high output electronic devices are actively made.

Recently, optical devices such as light emitting diodes (LEDs) and laser diodes (LDs) have been most actively developed for products. Blue and green LEDs have already come onto the market. Attempts have been made to develop LEDs having a longer wavelength and a shorter wavelength in the ultraviolet range.

Further, a variety of attempts have been made to fabricate a white LED for emitting white light by using a nitride-based semiconductor material.

As for white LEDs, products using blue LEDs and yellow phosphor have come onto the market. Attempts have been actively made to produce white light by combining an ultraviolet LED having a wavelength of 400nm or less and RGB phosphors.

Furthermore, a LD having a wavelength of 405nm is selected as a light source for writing on a next-generation optical recording medium. Development for improving the output, reliability and the like of the LD is in progress.

However, there is a significant problem in that there is no substrate material suitable for applications of the nitride semiconductor materials on which research has been actively conducted.

Since a GaN single crystal substrate with a large area has not been commercialized, heterogeneous substrates with sapphire, silicone, silicone carbide (SiC) or the like are used. If a single crystal epitaxial thin film is grown, the heterogeneous substrates are problematic in that lots of defects such as threading dislocation are formed within the thin film due to large differences in the lattice constants and the coefficients of thermal expansion. Defects such as threading dislocation, which has been reported to be formed up to approximately 10⁹ to 10¹⁰/cm² in size, serve as a non-light emitting region, a path for a leakage current, and the like. Thus, these defects are causes of the degradation of optical and electrical properties of devices using nitride semiconductor materials.

Accordingly, a variety of studies have been made to obtain a high quality GaN epitaxial thin film with lower defect density.

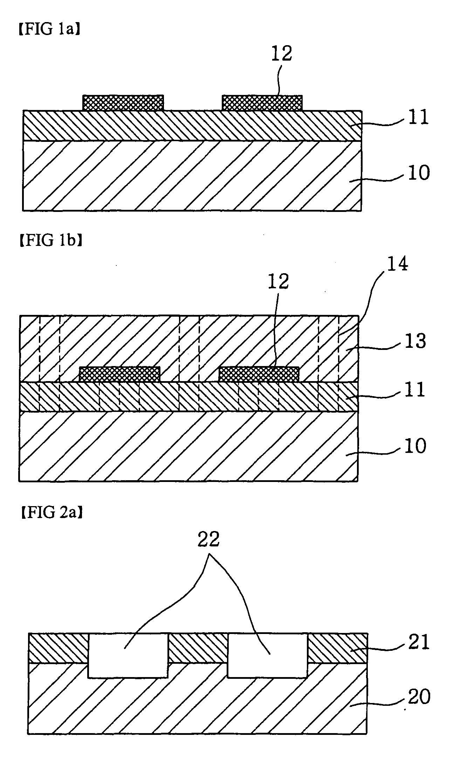

Figs. 1a and 1b are views illustrating a process of growing a nitride semiconductor thin film by means of a lateral growth method using a mask according to the prior art. The lateral growth method has been widely used. A first GaN thin film 11 is grown on a substrate 10, and a dielectric material film 12 of SiO₂ or the like is patterned on the first GaN thin film 11 (Fig. 1a).

Then, a second GaN thin film 13 is laterally grown using the patterned dielectric material film 12 (Fig. 1b).

At this time, the patterned dielectric material film 12 is used as a mask for blocking threading dislocation to prevent dislocation propagating below the mask from propagating toward the laterally growing thin film, so that only threading dislocation 14 in regions where the mask does not exist is propagated toward the surface of the growing thin film or the threading dislocation 14 is bent toward laterally growing portions of the thin film, thereby reducing the density of defects that reach the surface of the thin film.

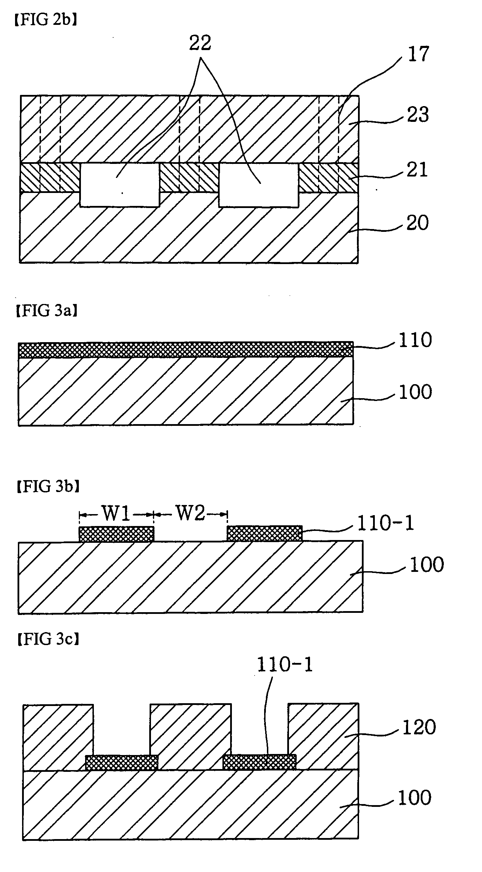

Figs. 2a and 2b are views illustrating a process of growing a nitride semiconductor thin film by means of a lateral growth method without using a mask according to the prior art. A first GaN thin film 21 is grown on a substrate 20, and some portions of the first GaN thin film 21 and the substrate 20 are etched to form a plurality of grooves 22 (Fig. 2a).

Then, a second GaN thin film 23 is formed by means of the lateral growth method using the plurality of the grooves 22 (Fig. 2b).

As shown in Fig. 2b, since dislocation 17 is not propagated toward portions of the second GaN thin film 23 grown on the plurality of etched grooves 22, it is possible to lower the defect density of the thin film.

However, the aforementioned conventional lateral growth method has a disadvantage in that the process is complicated since a GaN thin film is grown, a dielectric material film is formed and patterned and another GaN thin film is then grown; or a GaN thin film is grown, etched and then laterally grown.

Further, if a dielectric material film is used, there is a problem in that the growing GaN thin film becomes inclined due to stress generated between the laterally growing GaN thin film and the dielectric material film.

### SUMMARY OF THE INVENTION

The present invention is conceived to solve the aforementioned problems. Accordingly, an object of the present invention is to provide a high quality nitride semiconductor thin film and a method for growing the same, wherein mask material film patterns made of a dielectric or metallic material are formed on a substrate, the mask material film patterns are removed before coalescence is made while growing a nitride semiconductor thin film, and the nitride semiconductor thin film is laterally grown again, thereby growing a flat nitride semiconductor thin film with voids and fewer defects.

According to a first aspect of the present invention for achieving the object, there is provided a method for growing a high quality nitride semiconductor thin film, comprising a first step of forming a mask material film on a substrate, and etching the mask material film to form mask material film patterns through which some portions of a top surface of the substrate are exposed; a second step of growing a nitride semiconductor thin film on the portions of the substrate exposed through the mask material film patterns, and stopping the growth of the nitride semiconductor thin film before the occurrence of coalescence of the nitride semiconductor thin film, so that the mask material film patterns are exposed through the grown nitride semiconductor thin film; and a third step of etching and removing the exposed mask material film patterns and then continuously laterally growing the nitride semiconductor thin film such that coalescence of the nitride semiconductor thin film occurs, thereby forming a resultant nitride semiconductor thin film with a flat top surface and voids formed in regions where there previously were the mask material film patterns.

According to a second aspect of the present invention for achieving the object, there is provided a method for growing a high quality nitride semiconductor thin film, comprising the steps of forming mask material film patterns on a substrate; growing a nitride semiconductor thin film on portions of the substrate and the mask material film patterns except central portions of the mask material film patterns; etching and removing the mask material film patterns through the central portions of the mask material film patterns; laterally growing the nitride semiconductor thin film to form a resultant nitride semiconductor thin film with a flat top surface; and separating the substrate from the resultant nitride semiconductor thin film.

According to a third aspect of the present invention for achieving the object, there is provided a high quality nitride semiconductor thin film, comprising a substrate; and a nitride semiconductor thin film formed on the substrate and having void patterns formed at an interface between the nitride semiconductor thin film and the substrate.

### BRIEF DESCRIPTION OF THE DRAWINGS

The above and other objects, features and advantages of the present invention will become apparent from the following description of preferred embodiments given in conjunction with the accompanying drawings, in which:
Figs. 1a and 1b are views illustrating a process of growing a nitride semiconductor thin film by means of a lateral growth method using a mask according to the prior art;
Figs. 2a and 2b are views illustrating a process of growing a nitride semiconductor thin film by means of a lateral growth method without using a mask according to the prior art;
Figs. 3a to 3d are diagrammatic views illustrating a process of growing a high quality nitride semiconductor thin film according to the present invention;
Figs. 4a to 4f are plan views schematically showing mask material film patterns according to the present invention; and
Fig. 5 is a plan view showing a mask material film pattern in the form of a honeycomb according to the present invention.

### DETAILED DESCRIPTION OF THE INVENTION

Hereinafter, preferred embodiments of the present invention will be described in detail with reference to the accompanying drawings.

Figs. 3a to 3d are views illustrating a process of growing a high quality nitride semiconductor thin film according to the present invention. A mask material film 110 is formed on a substrate 100 (Fig. 3a), and the mask material film 110 is etched to form mask material film patterns 110-1 through which some of a top surface of the substrate 100 is exposed (Fig. 3b).

At this time, it is preferred that the substrate 100 be made of one selected from the group consisting of silicone carbide (SiC), sapphire, gallium arsenide (GaAs), silicone and ZnO.

Furthermore, it is preferred that the mask material film patterns 110-1 be constructed of a film made of one selected from the group consisting of SiO₂, Si₃Nₓ, TiN, W, Ni, Ti, Ta and WNₓ, or a laminated film of these materials.

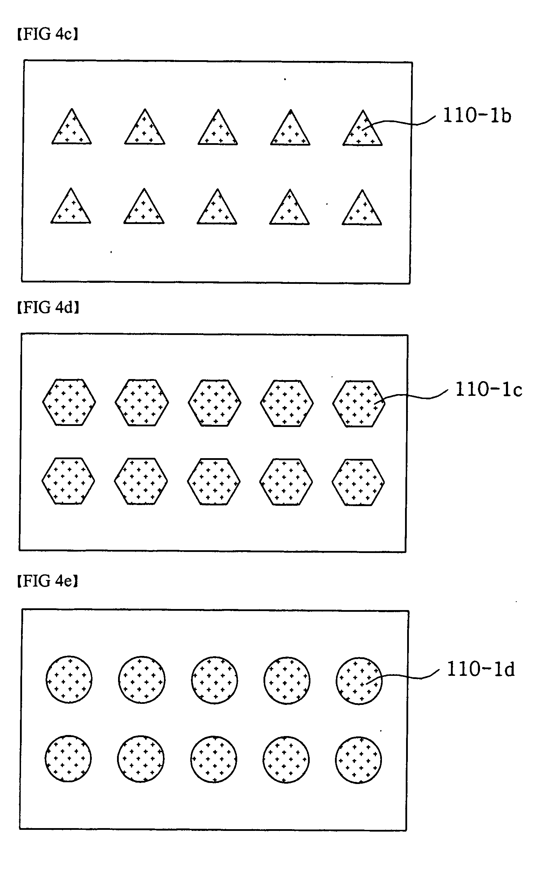

Moreover, the mask material film patterns 110-1 are composed of selected ones of rectangles (110-1a in Figs. 4a and 4b), triangles (110-1b in Fig. 4c), hexagons (110-1c in Fig. 4d) and circles (110-d in Fig. 4e) that are spaced apart from one another.

The mask material film patterns may also be patterns each of which has at least one joint (110-1e in Fig. 4f) bent at an angle of 120 degrees.

At this time, in the case of the mask material film patterns each of which has a joint bent at the angle of 120 degrees, GaN in the nitride semiconductor thin film can be smoothly grown on the bent mask material film bent at the angle of 120 degrees because it has a hexagonal system.

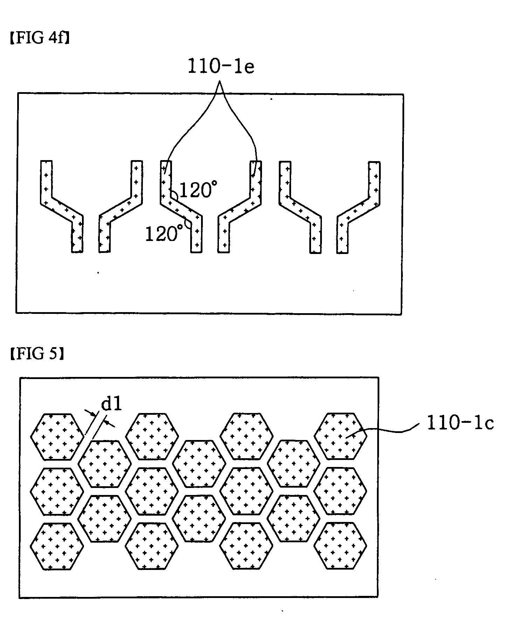

In the case of the mask material film patterns composed of spaced hexagons 110-1c, it is possible to form honeycomb-shaped mask material film patterns by maintaining a constant distance d1 between the spaced hexagons 110-1c, as shown in Fig. 5.

Furthermore, as shown in Fig. 3b, the width W1 of each of the mask material film patterns 110-1 and the width W2 of each of the exposed regions of the substrate 100 may be identical with each other.

A nitride semiconductor thin film 120 is grown on the regions of the substrate 100 that are exposed by the mask material film patterns 110-1, and the growth of the nitride semiconductor thin films 120 is stopped before the occurrence of coalescence of the nitride semiconductor thin film on the mask material film patterns 110-1, so that the mask material film patterns 110-1 are exposed through the grown nitride semiconductor thin film 120 (Fig. 3c).

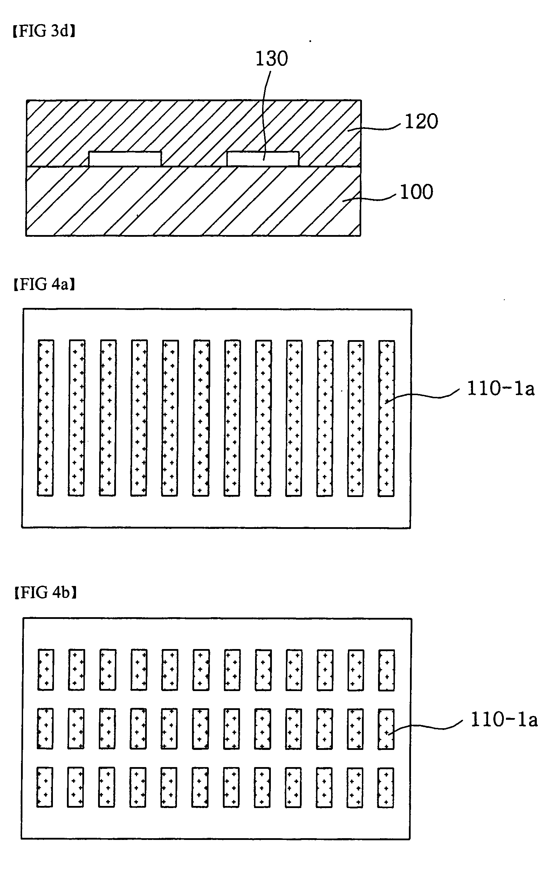

Thereafter, the exposed mask material film patterns 110-1 are etched and removed and the nitride semiconductor thin film 120 are then continuously laterally grown until the occurrence of coalescence of the nitride semiconductor thin film, so that a resultant nitride semiconductor thin film 120 has a flat top surface and voids 130 formed in the regions where there previously were the mask material film patterns 110-1 (Fig. 3d).

At this time, the void patterns formed at an interface between the substrate 100 and the nitride semiconductor thin film 120 have the same shape as the mask material film patterns.

Consequently, the high quality nitride semiconductor thin film according to the present invention comprises the substrate 100, and the nitride semiconductor thin film 120 which is formed on the substrate 100 and has the void patterns 130 formed at the interface between the nitride semiconductor thin film 120 and the substrate 100, as shown in Fig. 3d.

In this case, if the mask material film patterns 110-1 are formed out of a film of silicone oxide (SiO₂), the mask material film patterns 110-1 can be removed by dipping them into a HF or BOE solution.

Meanwhile, if the mask material film patterns 110-1 are made of Ni, the mask material film patterns 110-1 can be removed by dipping them into aqua regia (a mixture of hydrochloric acid and nitric acid).

That is, according to the present invention, the mask material film patterns are removed by means of a wet etching process.

Accordingly, the resultant nitride semiconductor thin film 120 that has been completely grown has the flat top surface and the void patterns 130.

Therefore, the portions of the nitride semiconductor thin film, which have been laterally grown on the mask material film patterns, have fewer defects than portions of the nitride semiconductor thin film that have been grown on the substrate. As a result, the grown nitride semiconductor thin film has fewer defects.

As described above, according to the present invention, mask material film patterns made of a dielectric or metallic material are formed on a substrate, the mask material film patterns are removed before coalescence is made while growing a nitride semiconductor thin film, and the nitride semiconductor thin film is laterally grown again, thereby growing a flat nitride semiconductor thin film with voids and fewer defects.

Moreover, according to the present invention, since the mask material film patterns are removed, stress generated at the interface between the mask material film patterns and the nitride semiconductor thin film can be eliminated, thereby enabling the growth of a nitride thin film with good crystallinity.

A conventional lateral growth method employs a multi-step process in which a nitride semiconductor thin film is grown on a substrate and a mask material is formed thereon or the nitride semiconductor thin film is etched, whereas the present invention employs a simple process in which a mask material is formed directly on a heterogeneous substrate.

In addition, according to the present invention, a nitride semiconductor thin film with voids is formed. Accordingly, since a light-emitting device employing the nitride semiconductor thin film does not produce total reflection of light in the void regions, a higher light emission efficiency can be obtained.

Meanwhile, if the substrate is separated from the nitride semiconductor thin film after the step of Fig. 3d, only the nitride semiconductor thin film remains. At this time, the substrate can be easily separated from the nitride semiconductor thin film due to the voids formed at the interface between the substrate and the nitride semiconductor thin film.

In this case, if the distance between the voids, i.e. the width of a region where the nitride semiconductor thin film adheres to the substrate, is small, the substrate can be more easily separated from the nitride semiconductor thin film.

If the area of the voids is converted based on the area of the nitride semiconductor thin film, it is preferred that the area of the voids be 60 to 90% of the area of the nitride semiconductor thin film.

According to the present invention described above, mask material film patterns made of a dielectric or metallic material are formed on a substrate, the mask material film patterns are removed before coalescence is made while growing a nitride semiconductor thin film, and the nitride semiconductor thin film is laterally grown again. Thus, there is an advantage in that it is possible to grow a flat nitride semiconductor thin film with voids and fewer defects.

Although the present invention has been illustrated and described in connection with the preferred embodiments, it will be readily understood by those skilled in the art that various modifications and changes can be made thereto without departing from the spirit and scope of the present invention. It is also apparent that the modifications and changes can fall within the scope of the present invention defined by the appended claims.

## Claims

1. A method for growing a high quality nitride semiconductor thin film, comprising:
a first step of forming a mask material film on a substrate, and etching the mask material film to form mask material film patterns through which some portions of a top surface of the substrate are exposed;
a second step of growing a nitride semiconductor thin film on the portions of the substrate exposed through the mask material film patterns, and stopping the growth of the nitride semiconductor thin film before the occurrence of coalescence of the nitride semiconductor thin film, so that the mask material film patterns are exposed through the grown nitride semiconductor thin film; and
a third step of etching and removing the exposed mask material film patterns and then continuously laterally growing the nitride semiconductor thin film such that coalescence of the nitride semiconductor thin film occurs, thereby forming a resultant nitride semiconductor thin film with a flat top surface and voids formed in regions where there previously were the mask material film patterns.

2. The method as claimed in claim 1, wherein the mask material film patterns are constructed of a film made of one selected from the group consisting of SiO₂ Si₃Nₓ, TiN, W, Ni, Ti, Ta and WNₓ, or a laminated film of these materials.

3. The method as claimed in claim 2, wherein the mask material film patterns are patterns composed of selected ones of rectangles, triangles, hexagons and circles that are spaced apart from one another, or patterns each of which has at least one joint bent at an angle of 120 degrees.

4. The method as claimed in claim 3, wherein the mask material film patterns with the spaced hexagons have a constant distance between the spaced hexagons.

5. The method as claimed in claim 1, wherein the substrate is made of one selected from the group consisting of silicone carbide (SiC), sapphire, gallium arsenide (GaAs), silicone, and ZnO.

6. The method as claimed in claim 1, wherein the area of the voids is 60 to 90% of that of the nitride semiconductor thin film.

7. A method for growing a high quality nitride semiconductor thin film, comprising the steps of:
forming mask material film patterns on a substrate;
growing a nitride semiconductor thin film on portions of the substrate and the mask material film patterns except central portions of the mask material film patterns;
etching and removing the mask material film patterns through the central portions of the mask material film patterns;
laterally growing the nitride semiconductor thin film to form a resultant nitride semiconductor thin film with a flat top surface; and
separating the substrate from the resultant nitride semiconductor thin film.

8. The method as claimed in claim 7, wherein the mask material film patterns are removed by means of a wet etching process.

9. The method as claimed in claim 7, wherein the mask material film patterns are constructed of a film made of one selected from the group consisting of SiO₂, Si₃Nₓ, TiN, W, Ni, Ti, Ta and WNₓ, or a laminated film of these materials.

10. The method as claimed in claim 7, wherein the mask material film patterns are patterns composed of selected ones of rectangles, triangles, hexagons and circles that are spaced apart from one another, or patterns each of which has at least one joint bent at an angle of 120 degrees.

11. The method as claimed in claim 7, wherein the mask material film patterns with the spaced hexagons have a constant distance between the spaced hexagons.

12. The method as claimed in claim 7, wherein the substrate is made of one selected from the group consisting of silicone carbide (SiC), sapphire, gallium arsenide (GaAs), silicone, and ZnO.

13. A high quality nitride semiconductor thin film, comprising:
a substrate; and
a nitride semiconductor thin film formed on the substrate and having void patterns formed at an interface between the nitride semiconductor thin film and the substrate.

14. The high quality nitride semiconductor thin film as claimed in claim 13, wherein the void patterns are patterns composed of selected ones of rectangles, triangles, hexagons and circles that are spaced apart from one another, or patterns each of which has at least one joint bent at an angle of 120 degrees.

15. The high quality nitride semiconductor thin film as claimed in claim 13 or 14, wherein the substrate is made of one selected from the group consisting of silicone carbide (SiC), sapphire, gallium arsenide (GaAs), silicone, and ZnO.

16. The high quality nitride semiconductor thin film as claimed in claim 13 or 14, wherein the area of the void patterns is 60 to 90% of that of the nitride semiconductor thin film.
